# EUROPÄISCHE PATENTSCHRIFT

(11) **EP 3 936 875 B1**
(45) Veröffentlichungstag und Bekanntmachung des Hinweises auf die Patenterteilung: **18.01.2023**
(21) Anmeldenummer: 21183274.6
(22) Anmeldetag: 01.07.2021
(51) Int. Cl.: G01R 27/02

(54) **WIDERSTANDSMESSSCHALTUNG, MESSEINRICHTUNG UND WIDERSTANDSMESSVERFAHREN**
RESISTANCE MEASURING CIRCUIT, MEASURING DEVICE AND RESISTANCE MEASURING METHOD
CIRCUIT DE MESURE DE LA RÉSISTANCE, DISPOSITIF DE MESURE ET PROCÉDÉ DE MESURE DE LA RÉSISTANCE

(30) Priorität: 07.07.2020 DE 102020004075
(43) Veröffentlichungstag der Anmeldung: 12.01.2022
(73) Patentinhaber: Diehl Metering GmbH, 91522 Ansbach (DE)
(72) Erfinder: Nickl, Stefan, 90547 Stein (DE)
(74) Vertreter: Diehl Patentabteilung

(56) Entgegenhaltungen:
- EP-A1- 0 821 223
- EP-A1- 0 836 085
- EP-A1- 1 251 357
- DE-A1- 4 420 998
- DE-C1- 10 134 635

## Beschreibung

Die Erfindung betrifft eine Widerstandsmessschaltung umfassend eine Steuereinrichtung, eine Kondensatorentladeschaltung und eine mit einer Versorgungsspannung verbundene Reihenschaltung aus wenigstens einem Schalter, wenigstens einem Messwiderstand, einem ersten Referenzwiderstand und einem zweiten Referenzwiderstand, wobei die Kondensatorentladeschaltung einen ersten Kondensator umfasst, welcher über eine Schalteinrichtung der Kondensatorentladeschaltung jeweils einzeln mit dem Messwiderstand, dem ersten Referenzwiderstand und mit einem ersten Eingang einer Vergleichseinrichtung der Kondensatorentladeschaltung verbindbar ist, wobei der erste Eingang der Vergleichseinrichtung mit einem Entladewiderstand der Kondensatorentladeschaltung verbunden ist. Weiterhin betrifft die Erfindung eine Messeinrichtung sowie ein Widerstandsmessverfahren.

Bei der Vermessung von Messwiderständen, deren Widerstandswert zur Messung einer weiteren physikalischen Größe herangezogen wird, ist es wünschenswert, wenn der Widerstandswert des Messwiderstands möglichst genau bestimmt werden kann. Über den Messwiderstand kann beispielsweise eine Temperaturmessung durchgeführt werden. Bei Messgeräten, welche mittels einer Widerstandsmessschaltung eine Temperaturmessung in mehreren Teilmessschritten durchführen, ist es wünschenswert, dass möglichst keine Beeinflussung der einzelnen Teilmessschritte von weiteren Zuständen des Messgeräts vorliegt, mithin also der eigentliche Messvorgang möglichst unabhängig z. B. von einer schwankenden Versorgungsspannung des Messgeräts ist. Zur Vermessung eines Messwiderstandes sind aus dem Stand der Technik verschiedene Verfahren bekannt.

In EP 0 836 085 A1 wird eine Widerstandsmessschaltung vorgeschlagen, welche eine Reihenschaltung aus zwei Referenzwiderständen und einen Messwiderstand aufweist. Dabei werden nacheinander der Messwiderstand und die beiden Referenzwiderstände jeweils einzeln über eine Multiplex-Schaltung zunächst mit einem Kondensator verbunden, um diesen zu laden. Anschließend wird die Entladezeit des Kondensators bestimmt, wobei aus den Messungen der Referenzwiderstände sowie des Messwiderstands der Widerstandswert des Messwiderstands ermittelt wird.

In DE 4 420 998 A1 wird eine Schaltungseinrichtung zum genauen Messen eines elektrischen Widerstands mit einem Mikrocontroller beschrieben. Der Mikrocontroller umfasst dazu mehrere Schaltanschlüsse sowie einen Unterbrecheranschluss, wobei an einem ersten Schaltanschluss ein elektrischer Kondensator, an einem zweiten Schaltanschluss ein erster Referenzwiderstand, an einem dritten Schaltanschluss der zu messende Widerstand und an einem vierten Schaltanschluss ein zweiter Referenzwiderstand angeschlossen sind. Der zu messende Widerstand bzw. die Referenzwiderstände sind mit dem Kondensator jeweils zu einem entsprechenden RC-Glied zusammenschaltbar. An einen Unterbrecheranschluss des Mikrocontrollers ist ein Komparator angeschlossen, wobei der Mikrocontroller zum Schalten des jeweiligen Schaltanschlusses eine Steuerung sowie einen mit dem Komparator verbundenen Zähler aufweist. Durch ein Verbinden des Kondensators mit den einzelnen Widerständen sowie durch ein bestimmen einer Entladezeit des sich dadurch jeweils ergebenden RC-Gliedes wird der zu messende Widerstand bestimmt.

Der Erfindung liegt die Aufgabe zugrunde, eine verbesserte Widerstandsmessschaltung anzugeben, welche insbesondere eine verbesserte Störunempfindlichkeit, insbesondere gegenüber Schwankungen einer Versorgungsspannung der Widerstandsmessschaltung, aufweist.

Zur Lösung dieser Aufgabe ist bei einer Widerstandsmessschaltung der eingangs genannten Art erfindungsgemäß vorgesehen, dass der zweite Referenzwiderstand parallel zu einem zweiten Kondensator der Kondensatorentladeschaltung geschaltet ist und der zweite Kondensator mit einem zweiten Eingang der Vergleichseinrichtung verbunden ist, wobei die Steuereinrichtung mit der Schalteinrichtung und der Vergleichseinrichtung verbunden ist und die Steuereinrichtung dazu eingerichtet ist, nacheinander den Messwiderstand und den ersten Referenzwiderstand mit dem ersten Kondensator zu verbinden und jeweils anschließend den ersten Kondensator mit dem ersten Eingang der Vergleichseinrichtung zu verbinden und über die Vergleichseinrichtung eine Entladezeit des ersten Kondensators zu ermitteln, wobei die Steuereinrichtung ferner dazu eingerichtet ist, aus einer Messentladezeit des über den Messwiderstand geladenen ersten Kondensators und einer Referenzentladezeit des über den ersten Referenzwiderstand geladenen ersten Kondensators einen den Widerstand des Messwiderstands beschreibenden Messwert zu ermitteln.

Bei einem Betrieb der Widerstandsmessschaltung kann somit zunächst der erste Kondensator über den Messwiderstand aufgeladen werden, sodass sich am ersten Kondensator eine dem Spannungsabfall über dem Messwiderstand entsprechende Spannung einstellt. Gleichzeitig stellt sich am zweiten Kondensator eine Spannung entsprechend dem Spannungsabfall über dem zweiten Referenzwiderstand ein. Anschließend kann die Entladezeit des ersten Kondensators bestimmt werden, wozu der erste Kondensator mit dem ersten Eingang der Vergleichseinrichtung und somit auch mit dem Entladewiderstand verbunden wird. Dabei wird die Zeit gemessen, welche die Spannung des ersten Kondensators benötigt, um bei Entladung des ersten Kondensators über den Entladewiderstand auf den Wert der am zweiten Kondensator anliegenden Spannung abzusinken. Die am zweiten Kondensator anliegende Spannung stellt somit eine Referenzspannung dar, welche aufgrund der Verbindung des zweiten Kondensators mit dem zweiten Referenzwiderstand der über dem zweiten Referenzwiderstand abfallenden Spannung entspricht. Bei der Messung der Entladezeiten des ersten Kondensators wird der zweite Kondensator nicht entladen, sodass die Spannung des zweiten Kondensators während des gesamten Entladevorgangs des ersten Kondensators zumindest im Wesentlichen konstant bleibt und als Referenzspannung herangezogen werden kann.

Bei dem Abfall einer Versorgungsspannung über der Reihenschaltung ist die über den jeweiligen Widerständen der Reihenschaltung abfallende Spannung proportional zu der Versorgungsspannung, so dass bei auftretenden Schwankungen der Versorgungsspannung auch die jeweils über den einzelnen Widerständen abfallende Spannung schwankt. Durch das Aufladen des zweiten Kondensators über den zweiten Referenzwiderstand zum Bereitstellen der Referenzspannung kann vorteilhaft eine Referenzspannung erzeugt werden, welche dem über dem zweiten Referenzwiderstand abfallenden Anteil der Versorgungsspannung zum Zeitpunkt des Öffnens des wenigstens einen Schalters entspricht. Auf diese Weise kann eine Information hinsichtlich der Versorgungsspannung zu diesem Zeitpunkt, welcher insbesondere einem Startzeitpunkt des Entladevorgangs des ersten Kondensators entspricht, in Form der am zweiten Kondensator anliegenden Referenzspannung gespeichert werden.

Gegenüber dem Verwenden einer während des Entladens des ersten Kondensators über den zweiten Widerstand abfallenden Spannung als Referenzspannung hat die Speicherung dieser Spannung im zweiten Kondensator den Vorteil, dass Schwankungen der Versorgungsspannung während dem Entladen des ersten Kondensators ohne Effekt auf die durch das Entladen des ersten Kondensators ermittelte Entladezeit bleiben. Dadurch können Schwankungen in der Versorgungsspannung während des Entladens des ersten Kondensators, also sowohl bei der Ermittlung der Messentladezeit als auch bei der Ermittlung der Referenzentladezeit, kompensiert werden, wodurch vorteilhaft auch die Ermittlung des den Widerstand des Messwiderstands beschreibenden Messwerts unempfindlich gegenüber eventuell auftretenden Schwankungen in der Versorgungsspannung durchgeführt werden kann. Schwankungen der Versorgungsspannung während einer Messperiode wirken sich somit nicht mehr negativ auf die Genauigkeit des Messergebnisses bei der Bestimmung des den Widerstand des Messwiderstands beschreibenden Messwerts, welcher aus der Messentladezeit des über den Messwiderstand geladenen ersten Kondensators und der Referenzentladezeit des über den ersten Referenzwiderstand geladenen ersten Kondensators bestimmt wird, aus.

Sowohl bei der Bestimmung der Messentladezeit des über den Messwiderstand geladenen ersten Kondensators als auch bei der Bestimmung der Referenzentladezeit des über den ersten Referenzwiderstand geladenen ersten Kondensators wird jeweils als Referenzspannung, bzw. als die am zweiten Eingang der Vergleichseinrichtung anliegende Spannung, die im zweiten Kondensator gespeicherte Spannung verwendet, welche aufgrund der Parallelschaltung des zweiten Kondensators mit dem zweiten Referenzwiderstand dem Spannungsabfall über dem zweiten Referenzwiderstand entsprechend dem aktuellen Stromfluss bzw. der aktuellen Versorgungsspannung beim Laden des ersten Kondensators entspricht.

Durch die Verwendung des ersten Referenzwiderstands und des zweiten Referenzwiderstands wird eine präzise Messung des Widerstandswerts des Messwiderstands ermöglicht, da temperaturabhängige Schwankungen, welche beispielsweise eine Kapazität des ersten Kondensators und/oder einen Widerstandswert des Entladewiderstands betreffen, auf diese Weise für jede Messung einzeln bestimmt und bei der Bestimmung des Widerstandswerts des Messwiderstands somit berücksichtigt werden können. Temperaturbedingte Schwankungen des aus der Reihenschaltung des ersten Kondensators und des Entladewiderstands gebildeten RC-Glieds, welche sich auf die jeweils ermittelte Entladezeit auswirken würden, können somit eliminiert werden. Die Verwendung der über den zweiten Referenzwiderstand abfallenden Referenzspannung bzw. die Speicherung dieser Spannung im zweiten Kondensator eliminiert vorteilhaft den Einfluss einer Schwankung des während der Messung fließenden Stroms bzw. von einer Schwankung der Versorgungsspannung, welche den während der Messung fließenden Strom bestimmt. Ferner kann durch den Wegfall einer aktiven Messung eines Spannungsabfalls über dem zweiten Referenzwiderstand, also eines Ladens und Entladens des ersten Kondensators über den zweiten Referenzwiderstand, ein Energieverbrauch der Widerstandsmessschaltung vorteilhaft reduziert werden. Außerdem verkürzt sich dadurch auch die insgesamt zur Ermittlung des den Widerstand des Messwiderstands beschreibenden Messwerts benötigte Messdauer, wodurch eine Auslastung der beispielsweise als Mikrocontroller ausgebildeten Steuereinrichtung vorteilhaft reduziert werden kann.

Über den wenigstens einen Schalter der Reihenschaltung kann nach dem Laden des ersten Kondensators über den Messwiderstand bzw. den ersten Referenzwiderstand und dem Einstellen des zweiten Kondensators auf den Spannungsabfall über dem zweiten Referenzwiderstand eine Trennung der Reihenschaltung von der Versorgungsspannung erfolgen, sodass während der Bestimmung der Entladezeit des ersten Kondensators kein Strom über die Reihenschaltung fließt, wodurch ein Energieverbrauch der Widerstandsmessschaltung vorteilhaft reduziert werden kann.

Die Reihenschaltung und der zweite Kondensator sowie der Entladewiderstand können insbesondere jeweils mit einem von der Versorgungsspannung verschiedenen Potential, insbesondere einem Bezugspotential der Versorgungsspannung bzw. einem Massepotential verbunden seien, sodass bei der Bestimmung der Messentladezeit bzw. der Referenzentladezeit jeweils eine Entladung des ersten Kondensators über den Entladewiderstand erfolgt.

In einer bevorzugten Ausgestaltung der Erfindung kann vorgesehen sein, dass ein erster Schalter der Reihenschaltung zwischen dem Messwiderstand und einem mit der Versorgungsspannung verbundenen ersten Anschluss der Reihenschaltung angeordnet ist und ein zweiter Schalter der Reihenschaltung zwischen einem, insbesondere mit einem Bezugspotential der Versorgungsspannung und/oder einem Massepotential verbundenen, zweiten Anschluss der Reihenschaltung und dem zweiten Referenzwiderstand angeordnet ist. Um den ersten Kondensator über den Messwiderstand bzw. den ersten Referenzwiderstand zu laden und den zweiten Kondensator auf eine Spannung entsprechend dem Spannungsabfall über dem zweiten Referenzwiderstand zu setzen, können jeweils der erste Schalter und der zweite Schalter geschlossen werden. Entsprechend können bei Verbindung des ersten Kondensators mit dem ersten Anschluss der Vergleichseinrichtung sowohl der erste Schalter als auch der zweite Schalter geöffnet werden, sodass keine weitere Beeinflussung der Spannung des ersten Kondensators sowie der Spannung des zweiten Kondensators bei der Ermittlung der Entladezeiten erfolgt. Durch das Öffnen des zweiten Schalters während des Entladens des ersten Kondensators wird vorteilhaft ein Entladen des zweiten Kondensators über den zweiten Referenzwiderstand verhindert.

Erfindungsgemäß kann vorgesehen sein, dass die Schalteinrichtung ein Multiplexer ist. Der Multiplexer kann dabei mit dem Messwiderstand und/oder dem ersten Referenzwiderstand über jeweils zwei Verbindungsleitungen verbunden sein, welche bezogen auf die Reihenschaltung jeweils vor bzw. hinter dem Messwiderstand bzw. dem ersten Referenzwiderstand angeordnet und mit dem Multiplexer verbunden sind. Die insbesondere als Multiplexer ausgebildete Schalteinrichtung ist mit der Steuerungseinrichtung verbunden, welche in einem Messbetrieb der Widerstandsmessschaltung die Vergleichseinrichtung zur Verbindung des Messwiderstands mit dem ersten Kondensator, des ersten Referenzwiderstands mit dem ersten Kondensator oder einer Verbindung des ersten Kondensators mit dem ersten Anschluss der Vergleichseinrichtung ansteuert.

Erfindungsgemäß kann vorgesehen sein, dass die Vergleichseinrichtung ein Komparator ist, welcher eine Messspannung an dem ersten Kondensator mit einer Referenzspannung an dem zweiten Kondensator vergleicht. Eine als Komparator ausgebildete Vergleichseinrichtung weist somit zum Beispiel am Ausgang logisch eine "1" auf, solange die über dem ersten Kondensator abfallenden Messspannung größer als die am zweiten Kondensator anliegende Referenzspannung ist. Aufgrund der Entladung des ersten Kondensators über den Entladewiderstand beim Bestimmen der Entladezeit sinkt die über dem ersten Kondensator abfallende Messspannung, wobei als jeweilige Entladezeit die Zeit bestimmt wird, die die am ersten Kondensator abfallende Messspannung braucht, um dem Spannungswert der über dem zweiten Kondensator anliegenden Referenzspannung zu entsprechen.

In einer bevorzugten Ausgestaltung der Erfindung kann vorgesehen sein, dass die Widerstandsmessschaltung mit einer Parallelschaltung aus einer Batterie und einem Kondensator zur Bereitstellung der Versorgungsspannung verbunden ist. Insbesondere in dieser Konstellation können Schwankungen in der Versorgungsspannung durch unterschiedliche Ladezustände des Kondensators, welcher beispielsweise als ein Elektrolytkondensator ausgeführt ist, auftreten. Diese Schwankungen können sich beispielsweise dadurch ergeben, dass die Widerstandsmessschaltung in ein Messgerät integriert ist, welches zusätzliche Komponenten aufweist, die ebenfalls durch die Versorgungsspannung gespeist werden. Dabei kann es sich beispielsweise um nur zu gewissen Zeitpunkten betriebene Komponenten, beispielsweise Schaltungen zur Datenübertragung bzw. zum Datenempfang oder Ähnliches, handeln. Diese Schaltungen können beim Senden bzw. Empfangen von Daten einen Einbruch in der Versorgungsspannung erzeugen, welcher bei einer zeitgleich durchgeführten Bestimmung des Widerstandswerts des Messwiderstands, insbesondere während des Entladens des ersten Kondensators, zu einer Verfälschung der Messung führen kann.

Vorteilhaft kann durch das erfindungsgemäße Verfahren auf Zuweisung einzelner Zeitslots beim Betreiben der Widerstandsmessschaltung und/oder weitere Komponenten einer die Widerstandsmessschaltung umfassenden Messeinrichtung verzichtet werden. Weiterhin kann auch bei Bereitstellung der Versorgungsspannung durch Batterie bzw. durch eine Parallelschaltung aus einer Batterie und einem Kondensator auf das Durchführen von Testmessungen bzw. Dummy-Messungen zum Erzeugen eines eingeschwungenen Zustands der Versorgungsspannungsversorgung verzichtet werden. Dies vereinfacht den Betrieb der Widerstandsmessschaltung, da vor der Aufnahme eines Messwertes keine weiteren Verfahrensschritte durchgeführt werden müssen. Ferner kann auch der Energieverbrauch der Widerstandsmessschaltung bzw. einer die Widerstandsmessschaltung umfassenden Messeinrichtung durch den Wegfall der Testmessungen reduziert werden.

In einer bevorzugten Ausgestaltung der Erfindung kann vorgesehen sein, dass die Reihenschaltung mehrere in Reihe geschaltete Messwiderstände umfasst, wobei die Steuereinrichtung dazu eingerichtet ist, nacheinander jeweils eine Messentladezeit des ersten Kondensators nach Aufladen über jeweils einen der Messwiderstände zu bestimmen. Auf diese Weise können beispielsweise Differenzmessungen zwischen den Widerständen von zwei oder mehr Messwiderständen, beispielsweise zur Ermittlung einer Temperaturdifferenz, durchgeführt werden.

Erfindungsgemäß kann vorgesehen sein, dass die Steuereinrichtung dazu ausgebildet ist, über den Messwiderstand eine Temperaturmessung, insbesondere zur Bestimmung einer Wärmemenge, durchzuführen. Dazu kann die Steuereinrichtung den einen Widerstandswert des Messwiderstands beschreibenden Messwert anhand einer beispielsweise in einer Speichereinrichtung der Steuerungseinrichtung hinterlegten Vorschrift verarbeiten.

Für eine erfindungsgemäße Messeinrichtung ist vorgesehen, dass diese eine erfindungsgemäße Widerstandsmessschaltung erfasst. Neben der Widerstandsmessschaltung kann die Messeinrichtung auch noch weitere Komponenten, beispielsweise Kommunikationseinrichtungen, insbesondere zum Datenempfang bzw. zum Senden von Daten, aufweisen.

Erfindungsgemäß kann vorgesehen sein, dass die Messeinrichtung ein Wärmemengenzähler ist. Ein über die Widerstandsmessschaltung ermittelter Wert des elektrischen Widerstands des Messwiderstands kann beispielsweise durch die Steuereinrichtung in eine korrespondierenden Wärmemenge umgerechnet werden und/oder über eine Kommunikationseinrichtung des Messgeräts an eine weitere Steuerungseinrichtung übermittelt werden.

Sämtliche vorangehend in Bezug zur erfindungsgemäßen Widerstandsmessschaltung beschriebenen Vorteile und Ausgestaltung gelten entsprechend für die erfindungsgemäße Messeinrichtung und umgekehrt.

Für ein erfindungsgemäßes Widerstandsmessverfahren ist vorgesehen, dass es eine Widerstandsmessschaltung mit einer Kondensatorentladeschaltung und einer mit einer Versorgungsspannung verbundenen Reihenschaltung aus wenigstens einem Schalter, wenigstens einem Messwiderstand, einem ersten Referenzwiderstand und einem zweiten Referenzwiderstand verwendet, wobei die Kondensatorentladeschaltung einen ersten Kondensator umfasst, welcher über eine Schalteinrichtung der Kondensatorentladeschaltung jeweils einzeln mit dem Messwiderstand, dem ersten Referenzwiderstand und mit einem ersten Eingang einer Vergleichseinrichtung der Kondensatorentladeschaltung verbindbar ist, wobei der erste Eingang der Vergleichseinrichtung mit einem Entladewiderstand der Kondensatorentladeschaltung verbunden ist, wobei der zweite Referenzwiderstand parallel zu einem zweiten Kondensator der Kondensatorentladeschaltung geschaltet ist und der zweite Kondensator mit einem zweiten Eingang der Vergleichseinrichtung verbunden ist, wobei das Verfahren die Schritte umfasst:
- Verbinden des Messwiderstands mit dem ersten Kondensator durch die Schalteinrichtung,
- Aufladen des ersten Kondensators über den Messwiderstand und Einstellen einer Spannung im zweiten Kondensator entsprechend einer Spannung an dem zweiten Referenzwiderstand durch Schließen des wenigstens einen Schalters der Reihenschaltung,
- Öffnen des wenigstens einen Schalters und Ermitteln einer Messentladezeit des ersten Kondensators durch die Vergleichseinrichtung unter Verwendung der Spannung des zweiten Kondensators als Referenzspannung,
- Verbinden des ersten Referenzwiderstands mit dem ersten Kondensator durch die Schalteinrichtung,
- Aufladen des ersten Kondensators über den ersten Referenzwiderstand und Einstellen einer Spannung im zweiten Kondensator entsprechend einer Spannung an dem zweiten Referenzwiderstand durch Schließen des wenigstens einen Schalters der Reihenschaltung,
- Öffnen des wenigstens einen Schalters und Ermitteln einer Referenzentladezeit des ersten Kondensators durch die Vergleichseinrichtung unter Verwendung der Spannung des zweiten Kondensators als Referenzspannung,
- Ermitteln eines einen Widerstand des Messwiderstands beschreibenden Messwerts aus der Messentladezeit und der Referenzentladezeit.

Die Schritte des Aufladens des ersten Kondensators über den Messwiderstand sowie des Aufladens des ersten Kondensators über den ersten Referenzwiderstand können dabei in beliebiger Reihenfolge durchgeführt werden, das heißt, das ist sowohl möglich, dass zuerst der Messwiderstand und dann der erste Referenzwiderstand zum Laden des ersten Kondensators verwendet wird, als auch das zuerst der erste Referenzwiderstand und dann der Messwiderstand zum Laden des ersten Kondensators herangezogen wird. Es ist auch möglich, dass neben dem Messwiderstand auch ein weiterer Messwiderstand vor und/oder nach der Messung des Messwiderstands bzw. des ersten Referenzwiderstands mit dem ersten Kondensator verbunden wird, wobei der erste Kondensator über den weiteren Messwiderstand geladen und am zweiten Kondensator eine Spannung entsprechend einem Spannungsabfall über dem zweiten Referenzwiderstand eingestellt wird. Anschließend kann eine weitere Messentladezeit des weiteren Messwiderstands durch das Öffnen des wenigstens eines Schalters und durch die Vergleichseinrichtung unter Verwendung der Spannung des zweiten Kondensators als Referenzspannung ermittelt werden.

Sämtliche vorangehend in Bezug zur erfindungsgemäßen Widerstandsmessschaltung bzw. zur erfindungsgemäßen Messeinrichtung beschriebenen Vorteile und Ausgestaltungen gelten entsprechend auch für das erfindungsgemäße Widerstandsmessverfahren und umgekehrt.

Weitere Vorteile und Ausgestaltungen der Erfindung ergeben sich aus den im Folgenden beschriebenen Ausführungsbeispielen sowie anhand der Zeichnung. Die Zeichnungen sind schematische Darstellungen und zeigen:
- Fig. 1: ein Schaltplan eines Ausführungsbeispiels einer erfindungsgemäßen Widerstandsmessschaltung,
- Fig. 2: ein Ausführungsbeispiel einer erfindungsgemäßen Messeinrichtung und
- Fig. 3: ein Flussdiagramm eines Ausführungsbeispiels eines erfindungsgemäßen Widerstandsmessverfahrens.

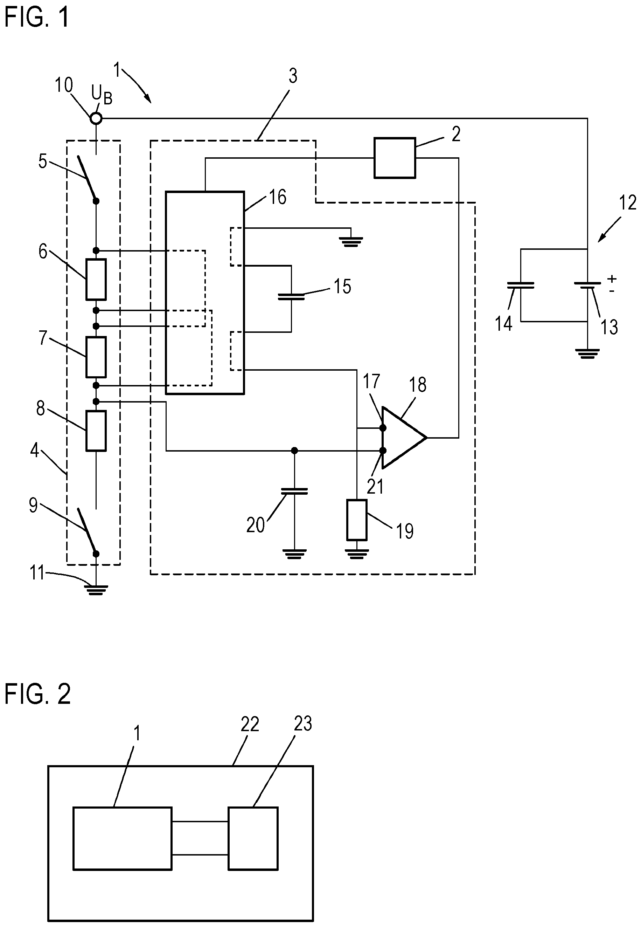

In Fig. 1 ist ein Ausführungsbeispiel einer Widerstandsmessschaltung 1 dargestellt. Die Widerstandsmessschaltung 1 umfasst eine beispielsweise als Mikrocontroller ausgebildete Steuereinrichtung 2, eine Kondensatorentladeschaltung 3 und eine mit einer Versorgungsspannung verbundene Reihenschaltung 4, welche einen ersten Schalter 5, einen Messwiderstand 6, einen ersten Referenzwiderstand 7 sowie einen zweiten Referenzwiderstand 8 umfasst. Weiterhin umfasst die Reihenschaltung 4 einen zweiten Schalter 9.

Der erste Schalter 5 ist zwischen den Messwiderstand 6 und einen ersten Anschluss 10 der Reihenschaltung 4 geschaltet. Der zweite Schalter 9 ist zwischen den zweiten Referenzwiderstand 8 und einen zweiten Anschluss 11 der Reihenschaltung 4 geschaltet, wobei an dem ersten Anschluss 10 der Reihenschaltung 4 eine Versorgungsspannung U_{B} anliegt. Am zweiten Anschluss 11 liegt ein Bezugspotential der Versorgungsspannung U_{B}, z. B. ein Massepotential, an. Die Versorgungsspannung U_{B} wird von einer Spannungsquelle 12 erzeugt, welche eine Batterie 13 sowie einen als Elektrolytkondensator ausgeführten Kondensator 14 umfasst. Der Kondensator 14 ist dabei parallel zu der Batterie 13 geschaltet.

Die Kondensatorentladeschaltung 3 umfasst einen ersten Kondensator 15, welcher über eine Schalteinrichtung 16 der Kondensatorentladeschaltung 3 jeweils einzeln mit dem Messwiderstand 6, dem ersten Referenzwiderstand 7 und einem ersten Eingang 17 einer Vergleichseinrichtung 18 der Kondensatorentladeschaltung 3 verbunden werden kann. Die durch die Schalteinrichtung 16 jeweils bereitstellbaren Verbindungen sind gestrichelt dargestellt. An dem ersten Eingang 17 der Vergleichseinrichtung 18 ist weiterhin ein Entladewiderstand 19 angeschlossen, über welchen der erste Eingang 17 mit dem Referenz- bzw. Massepotential verbunden wird. Die Schalteinrichtung 16 ist als ein Multiplexer ausgeführt, deren unterschiedliche Schaltzustände von der Steuerungseinrichtung 2 eingestellt werden können. Die Vergleichseinrichtung 18 ist als ein Komparator ausgeführt, dessen Ausgang mit der Steuerungseinrichtung 2 verbunden ist. Der Komparator 18 kann weiterhin mit einer zur Bereitstellung eines logischen Signals am Ausgang verwendeten Spannung (hier nicht dargestellt) verbunden sein.

Der zweite Referenzwiderstand 8 ist parallel zu einem zweiten Kondensator 20 der Kondensatorentladeschaltung 3 geschaltet, wobei der zweite Kondensator 20 zwischen einen zweiten Anschluss 21 der Vergleichseinrichtung 18 und das Masse- bzw. Referenzpotential der Versorgungsspannung geschaltet ist.

Die Steuereinrichtung 2 ist mit der Schalteinrichtung 16 sowie mit der Vergleichseinrichtung 18 verbunden. Durch die Steuereinrichtung 2 kann die Schalteinrichtung 16 angesteuert werden, um wahlweise den Messwiderstand 6 oder den ersten Referenzwiderstand 7 mit dem ersten Kondensator 15 zu verbinden bzw. um den ersten Kondensator 15 mit der Vergleichseinrichtung 18 zu verbinden.

Die Steuerungseinrichtung 2 ist ferner dazu eingerichtet, eine Entladezeit des ersten Kondensators 15 zu ermitteln, wobei die Steuereinrichtung 2 aus einer Messentladezeit einer Entladung des über den Messwiderstand 6 geladenen ersten Kondensators 15 und einer Referenzentladezeit einer Entladung des über den Referenzwiderstand 7 geladenen ersten Kondensators 15 einen den Widerstand des Messwiderstands 6 beschreibenden Messwert ermittelt.

Um den einen Widerstand des Messwiderstands beschreibenden Messwert zu ermitteln, kann zunächst der Messwiderstand 6 über die Schalteinrichtung 16 mit dem ersten Kondensator 15 verbunden werden. Durch Schließen des ersten Schalters 5 sowie des zweiten Schalters 9 fällt die Versorgungsspannung U_{B} über der gesamten Reihenschaltung 4 ab. Aufgrund der Verbindung des Messwiderstands 6 mit dem ersten Kondensator 15 wird der erste Kondensator 15 auf eine Spannung geladen, welche den Spannungsabfall über den Messwiderstand 6 entspricht. Aufgrund der Parallelschaltung des zweiten Referenzwiderstands 8 und den das zweiten Kondensators 20 wird der zweite Kondensator 20 entsprechend auf eine Spannung eingestellt, welche dem Spannungsabfall über dem zweiten Referenzwiderstand 8 entspricht.

Anschließend kann durch Ansteuerung der Schalter 5, 9 durch die Steuereinrichtung 2 ein Öffnen der Schalter 5, 9 erfolgen. Durch ein Ansteuern der Schalteinrichtung 16 durch die Steuerungseinrichtung 2 erfolgt eine Verbindung des ersten Kondensators 15 mit dem ersten Anschluss 17 der Vergleichseinrichtung 18. Somit liegt an dem ersten Anschluss 17 der Vergleichseinrichtung 18 die im ersten Kondensator 15 gespeicherte Spannung als eine Messspannung an. Entsprechend liegt am zweiten Anschluss 21 die im zweiten Kondensator 20 gespeicherte Spannung als eine Referenzspannung an. Aufgrund der Verbindung des ersten Anschlusses 17 der Vergleichseinrichtung 18 mit dem Entladewiderstand 19 wird der erste Kondensator 15 über den Entladewiderstand 19 entladen. An dem mit der Steuereinrichtung 2 verbundenen Ausgang der Vergleichseinrichtung 18 liegt solange eine logische "1", beispielsweise in Form eines definierten Potentials, an, wie die Spannung des ersten Kondensators 15 höher als die Referenzspannung am zweiten Anschluss 21 ist, welche von dem zweiten Kondensator 20 gestellt wird. Dadurch kann die Steuereinrichtung 2 durch die Vergleichseinrichtung 18 eine Messentladezeit des ersten Kondensators 15 bestimmen.

Danach erfolgt durch die Schalteinrichtung 16 eine Verbindung des ersten Referenzwiderstands 7 mit dem ersten Kondensator 15 sowie ein Schließen des ersten Schalters 5 und des zweiten Schalters 9. Dabei wird der erste Kondensator 15 auf eine Spannung geladen, welche dem Spannungsabfall über dem ersten Referenzwiderstand 7 entspricht. Entsprechend stellt sich im zweiten Kondensator 20 eine Spannung ein, welche dem Spannungsabfall über dem zweiten Referenzwiderstand 8 entspricht. Durch eine Ansteuerung der Schalteinrichtung 16 durch die Steuereinrichtung 2 wird dann erneut der erste Kondensator 15 mit der Vergleichseinrichtung 18 verbunden, sodass durch die Steuereinrichtung 2 eine Referenzentladezeit des ersten Kondensators 15 ermittelt werden kann. Aus den Messwerten der Messentladezeit sowie der Referenzentladezeit kann durch die Steuereinrichtung 2 ein den Widerstand des Messwiderstands 6 beschreibender Messwert ermittelt werden. Über den Messwiderstand 6 kann beispielsweise in definierten Zeitabständen jeweils eine Temperaturmessung durchgeführt werden, in dem der Widerstandswert des Messwiderstands 6 als ein Maß für die Temperatur herangezogen wird. Es ist möglich, dass die Reihenschaltung 4 zusätzlich zu dem Messwiderstand 6 einen oder mehrere weitere Messwiderstände umfasst, welche ebenfalls in Reihe in der Reihenschaltung 4 verschaltet sind. Eine einem weiteren Messwiderstand zugeordnete Messentladezeit kann entsprechend der Messentladezeit der Messwiderstands 6 ermittelt werden. Auch ein einen Widerstand eines weiteren Messwiderstands beschreibender weiterer Messwert kann analog aus der Messentladezeit des weiteren Messwiderstands ermittelt werden.

Durch das Verwenden des ersten Referenzwiderstands bzw. der Referenzentladezeit können temperaturbedingte Schwankungen der Entladezeit, welche sich aus der Kapazität des ersten Kondensators 15 sowie dem Widerstandswert des Entladewiderstands 19 ergeben, kompensiert werden.

Das Verwenden der über den zweiten Referenzwiderstand 8 abfallenden Spannung als Referenzspannung in der Vergleichseinrichtung 18 ermöglicht es vorteilhaft, Spannungsschwankungen der Versorgungsspannung U_{B} auszugleichen, welche beispielsweise durch eine Belastung der Batterie 13 und/oder des Kondensators 14 während der Durchführung der Widerstandsmessung auftreten können. Solche Belastungen können beispielsweise die Folge eines Betriebes von weiteren Schaltungselementen sein, welche ebenfalls über die Spannungsquelle 12 betrieben bzw. versorgt werden.

In Fig. 2 ist ein Ausführungsbeispiel einer Messeinrichtung 22 dargestellt. Die Messeinrichtung 22 umfasst eine erfindungsgemäße Widerstandsmessschaltung 1 sowie eine Kommunikationseinrichtung 23. Die Kommunikationseinrichtung 23 wird dabei ebenfalls durch die Spannungsquelle 12 der Widerstandsmessschaltung 1 gespeist und dient der Übermittlung wenigstens eines von der Steuereinrichtung 2 der Widerstandsmessschaltung 1 ermittelten, einen Wert für den Widerstand des Messwiderstands 6 darstellenden Messwerts. Die Widerstandsmessschaltung 1 ist dabei entsprechend dem in Fig. 1 beschriebenen Ausführungsbeispiel ausgestaltet, sodass vorteilhaft Schwankungen der Versorgungsspannung U_{B}, welche sich durch einen Betrieb der Kommunikationseinrichtung 23 ergeben, ohne Einfluss auf die Ermittlung eines Messwerts bleiben. Die Messeinrichtung 22 kann zu einer Temperaturmessung, insbesondere zur Bestimmung einer Wärmemenge, ausgebildet sein. Beispielsweise kann die Messeinrichtung 22 ein Wärmemengenzähler sein.

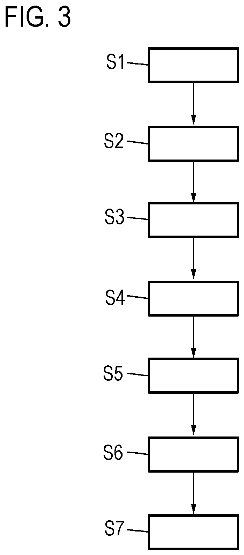

In Fig. 3 ist ein Flussdiagramm eines erfindungsgemäßen Widerstandsmessverfahrens dargestellt. Das Widerstandsmessverfahren kann dabei beispielsweise unter Verwendung einer Widerstandsmessschaltung gemäß des in Fig. 1 gezeigten Ausführungsbeispiels durchgeführt werden. Das Ausführungsbeispiel des Widerstandsmessverfahrens umfasst als einen ersten Schritt S1 das Verbinden des Messwiderstands 6 mit dem ersten Kondensator 15 durch die Schalteinrichtung 16. In einem anschließenden Schritt S2 erfolgt das Aufladen des ersten Kondensators 15 über den Messwiderstand 6 sowie das Aufladen des zweiten Kondensators 20 über den zweiten Referenzwiderstand 8 durch Schließen des ersten Schalters 5 sowie des zweiten Schalters 9.

In Schritt S3 werden nach einer vorgegebenen Zeit, welche ausreichend ist, um sowohl den ersten Kondensator 15 als auch den zweiten Kondensator 20 aufzuladen, das heißt, dass der erste Kondensator 15 nach dieser Zeit eine Spannung entsprechend der über dem Messwiderstand 6 abfallenden Spannung und der zweite Kondensator 20 eine Spannung entsprechend der über den zweiten Referenzwiderstand 8 abfallenden Spannung aufweist, der erste Schalter 5 und der zweite Schalter 9 geöffnet. Weiterhin wird eine Messentladezeit des ersten Kondensators 15 durch die Vergleichseinrichtung 18 ermittelt, wobei die Spannung des zweiten Kondensators 20 als Referenzspannung verwendet wird. Dabei wird die Zeit bestimmt, welche die Spannung des ersten Kondensators benötigt, um auf den Wert der Referenzspannung abzufallen.

Anschließend erfolgt in Schritt S4 das Verbinden des ersten Referenzwiderstands 7 mit dem ersten Kondensator 15. Die Verbindung des ersten Kondensators mit der ersten Anschluss 17 der Vergleichseinrichtung 18 wird dabei getrennt.

In Schritt S5 erfolgt das Aufladen des ersten Kondensators 15 über den ersten Referenzwiderstand 6 sowie ein erneutes Einstellen des zweiten Kondensators 20 auf die über dem zweiten Referenzwiderstand 8 abfallende Spannung. Auch wenn der zweite Referenzwiderstand 20 bei der Bestimmung der Entladezeit nicht entladen wird, wird durch das erneute Verbinden des zweiten Kondensators 20 mit dem zweiten Referenzwiderstand 8 sichergestellt, dass die im nachfolgenden Messvorgang zum Bestimmen der Entladezeit des über den ersten Referenzwiderstand 7 geladenen ersten Kondensators 15 als Referenzspannung verwendete Spannung des Kondensators 20 dem beim Laden des ersten Kondensators 15 durch den ersten Referenzwiderstand 7 fließenden Strom entspricht.

In Schritt S6 werden der erste Schalter 5 und zweite Schalter 9 geöffnet und es wird eine Referenzentladezeit des ersten Kondensators 15 durch die Vergleichseinrichtung 18 unter Verwendung der Spannung des zweiten Kondensators 20 als Referenzspannung durchgeführt. Anschließend erfolgt in Schritt S7 das Ermitteln eines einen Widerstand des Messwertes 6 beschreibenden Messwerts aus der Messentladezeit und der Referenzentladezeit. Anschließend kann das Verfahren beispielsweise erneut mit Schritt 1 fortfahren.

Es ist möglich, dass weitere Messwiderstände in zusätzlichen Schritten des Widerstandsmessverfahrens vermessen werden, sodass mehr als ein Widerstandswert eines Messwiderstands bestimmt werden kann. Die Reihenfolge, in der der wenigstens einen Messwiderstand 6 der erste Referenzwiderstand 7 vermessen werden, ist nicht festgelegt, sodass die Schritte S4-S6 auch vor dem Schritten S1-S3 ausgeführt werden können.

### Bezugszeichenliste

- 1: Widerstandsmessschaltung
- 2: Steuereinrichtung
- 3: Kondensatorentladeschaltung
- 4: Reihenschaltung
- 5: Schalter
- 6: Messwiderstand
- 7: Referenzwiderstand
- 8: Referenzwiderstand
- 9: Schalter
- 10: Anschluss
- 11: Anschluss
- 12: Spannungsquelle
- 13: Batterie
- 14: Kondensator
- 15: Kondensator
- 16: Schalteinrichtung
- 17: Anschluss
- 18: Vergleichseinrichtung
- 19: Entladewiderstand
- 20: Kondensator
- 21: Anschluss
- 22: Messeinrichtung
- 23: Kommunikationseinrichtung
- U_{B}: Versorgungsspannung
- S1-S7: Schritt

## Patentansprüche

1. Widerstandsmessschaltung umfassend eine Steuereinrichtung (2), eine Kondensatorentladeschaltung (3) und eine mit einer Versorgungsspannung verbundene Reihenschaltung (4) aus wenigstens einem Schalter (5, 9), wenigstens einem Messwiderstand (6), einem ersten Referenzwiderstand (7) und einem zweiten Referenzwiderstand (8), wobei die Kondensatorentladeschaltung (3) einen ersten Kondensator (15) umfasst, welcher über eine Schalteinrichtung (16) der Kondensatorentladeschaltung (3) jeweils einzeln mit dem Messwiderstand (6), dem ersten Referenzwiderstand (7) und mit einem ersten Eingang (17) einer Vergleichseinrichtung (18) der Kondensatorentladeschaltung (3) verbindbar ist, wobei der erste Eingang (17) der Vergleichseinrichtung (18) mit einem Entladewiderstand (19) der Kondensatorentladeschaltung (3) verbunden ist, wobei der zweite Referenzwiderstand (8) parallel zu einem zweiten Kondensator (20) der Kondensatorentladeschaltung (3) geschaltet ist und der zweite Kondensator (20) mit einem zweiten Eingang (21) der Vergleichseinrichtung (18) verbunden ist, wobei die Steuereinrichtung (2) mit der Schalteinrichtung (16) und der Vergleichseinrichtung (18) verbunden ist und die Steuereinrichtung (2) dazu eingerichtet ist, nacheinander den Messwiderstand (6) und den ersten Referenzwiderstand (7) mit dem ersten Kondensator (15) zu verbinden und jeweils anschließend den ersten Kondensator (7) mit dem ersten Eingang (17) der Vergleichseinrichtung (18) zu verbinden und über die Vergleichseinrichtung (18) eine Entladezeit des ersten Kondensators (15) zu ermitteln, wobei die Steuereinrichtung (2) ferner dazu eingerichtet ist, aus einer Messentladezeit des über den Messwiderstand (6) geladenen ersten Kondensators (15) und einer Referenzentladezeit des über den ersten Referenzwiderstand (7) geladenen ersten Kondensators (15) einen den Widerstand des Messwiderstands (6) beschreibenden Messwert zu ermitteln.

2. Widerstandsmessschaltung nach Anspruch 1,
**dadurch gekennzeichnet,**
**dass** ein erster Schalter (5) der Reihenschaltung (4) zwischen dem Messwiderstand (6) und einem mit der Versorgungsspannung verbundenen ersten Anschluss (10) der Reihenschaltung (4) angeordnet ist und ein zweiter Schalter (9) der Reihenschaltung (4) zwischen einem, insbesondere mit einem Bezugspotential der Versorgungsspannung und/oder einem Massepotential verbundenen, zweiten Anschluss (11) der Reihenschaltung (4) und dem zweiten Referenzwiderstand (8) angeordnet ist.

3. Widerstandsmessschaltung nach Anspruch 1 oder 2,
**dadurch gekennzeichnet,**
**dass** die Schalteinrichtung (16) ein Multiplexer ist.

4. Widerstandsmessschaltung nach einem der vorangehenden Ansprüche,
**dadurch gekennzeichnet,**
**dass** die Vergleichseinrichtung (18) ein Komparator ist, welcher eine Messspannung an dem ersten Kondensator (15) mit einer Referenzspannung an dem zweiten Kondensator (20) vergleicht.

5. Widerstandsmessschaltung nach einem der vorangehenden Ansprüche,
**dadurch gekennzeichnet,**
**dass** die Widerstandmessschaltung (1) mit einer Parallelschaltung aus einer Batterie (13) und einem Kondensator (14) zur Bereitstellung der Versorgungsspannung verbunden ist.

6. Widerstandsmessschaltung nach einem der vorangehenden Ansprüche,
**dadurch gekennzeichnet,**
**dass** die Reihenschaltung (4) mehrere in Reihe geschaltete Messwiderstände (6) umfasst, wobei die Steuereinrichtung (2) dazu eingerichtet ist, nacheinander jeweils eine Messentladezeit des ersten Kondensators (15) nach Aufladen über jeweils einen der Messwiderstände (6) zu bestimmen.

7. Widerstandsmessschaltung nach einem der vorangehenden Ansprüche,
**dadurch gekennzeichnet,**
**dass** die Steuereinrichtung (2) dazu ausgebildet ist, über den Messwiderstand (6) eine Temperaturmessung, insbesondere zur Bestimmung einer Wärmemenge, durchzuführen.

8. Messeinrichtung umfassend eine Widerstandsmessschaltung (1) nach einem der vorangehenden Ansprüche.

9. Messeinrichtung nach Anspruch 8,
**dadurch gekennzeichnet,**
**dass** die Messeinrichtung (22) ein Wärmemengenzähler ist.

10. Widerstandsmessverfahren unter Verwendung einer Widerstandsmessschaltung (1) mit einer Kondensatorentladeschaltung (3) und einer mit einer Versorgungsspannung verbundenen Reihenschaltung (4) aus wenigstens einem Schalter (5, 9), wenigstens einem Messwiderstand (6), einem ersten Referenzwiderstand (7) und einem zweiten Referenzwiderstand (8), wobei die Kondensatorentladeschaltung (3) einen ersten Kondensator (15) umfasst, welcher über eine Schalteinrichtung (16) der Kondensatorentladeschaltung (3) jeweils einzeln mit dem Messwiderstand (6), dem ersten Referenzwiderstand (7) und mit einem ersten Eingang (17) einer Vergleichseinrichtung (18) der Kondensatorentladeschaltung (3) verbindbar ist, wobei der erste Eingang (17) der Vergleichseinrichtung (18) mit einem Entladewiderstand (19) der Kondensatorentladeschaltung (3) verbunden ist, wobei der zweite Referenzwiderstand (8) parallel zu einem zweiten Kondensator (20) der Kondensatorentladeschaltung (3) geschaltet ist und der zweite Kondensator (20) mit einem zweiten Eingang (21) der Vergleichseinrichtung (18) verbunden ist, umfassend die Schritte:
- Verbinden des Messwiderstands (6) mit dem ersten Kondensator (15) durch die Schalteinrichtung (16),
- Aufladen des ersten Kondensators (15) über den Messwiderstand (6) und Einstellen einer Spannung im zweiten Kondensator (20) entsprechend einer Spannung an dem zweiten Referenzwiderstand (8) durch Schließen des wenigstens einen Schalters (5, 9) der Reihenschaltung (4),
- Öffnen des wenigstens einen Schalters (5, 9) und Ermitteln einer Messentladezeit des ersten Kondensators (15) durch die Vergleichseinrichtung (18) unter Verwendung der Spannung des zweiten Kondensators (20) als Referenzspannung,
- Verbinden des ersten Referenzwiderstands (7) mit dem ersten Kondensator (15) durch die Schalteinrichtung (16),
- Aufladen des ersten Kondensators (15) über den ersten Referenzwiderstand (7) und Einstellen einer Spannung im zweiten Kondensator (20) entsprechend einer Spannung an dem zweiten Referenzwiderstand (8) durch Schließen des wenigstens einen Schalters (5, 9) der Reihenschaltung (4),
- Öffnen des wenigstens einen Schalters (5, 9) und Ermitteln einer Referenzentladezeit des ersten Kondensators (15) durch die Vergleichseinrichtung (18) unter Verwendung der Spannung des zweiten Kondensators (20) als Referenzspannung,
- Ermitteln eines einen Widerstand des Messwiderstands (6) beschreibenden Messwerts aus der Messentladezeit und der Referenzentladezeit.

## Claims

1. Resistance measuring circuit comprising a control apparatus (2), a capacitor discharge circuit (3) and a series circuit (4) that is connected to a supply voltage and comprises at least one switch (5, 9), at least one measuring resistor (6), a first reference resistor (7) and a second reference resistor (8), wherein the capacitor discharge circuit (3) comprises a first capacitor (15) that is connectable in each case individually to the measuring resistor (6), the first reference resistor (7) and to a first input (17) of a comparison apparatus (18) of the capacitor discharge circuit (3) via a switching apparatus (16) of the capacitor discharge circuit (3), wherein the first input (17) of the comparison apparatus (18) is connected to a discharge resistor (19) of the capacitor discharge circuit (3), wherein the second reference resistor (8) is connected in parallel with a second capacitor (20) of the capacitor discharge circuit (3) and the second capacitor (20) is connected to a second input (21) of the comparison apparatus (18), wherein the control apparatus (2) is connected to the switching apparatus (16) and the comparison apparatus (18) and the control apparatus (2) is designed to successively connect the measuring resistor (6) and the first reference resistor (7) to the first capacitor (15) and in each case then to connect the first capacitor (7) to the first input (17) of the comparison apparatus (18) and to ascertain a discharge time of the first capacitor (15) by way of the comparison apparatus (18), wherein the control apparatus (2) is also designed to ascertain a measured value describing the resistance of the measuring resistor (6) from a measured discharge time of the first capacitor (15) charged via the measuring resistor (6) and a reference discharge time of the first capacitor (15) charged via the first reference resistor (7).

2. Resistance measuring circuit according to Claim 1,
**characterized**
**in that** a first switch (5) of the series circuit (4) is arranged between the measuring resistor (6) and a first connection (10), which is connected to the supply voltage, of the series circuit (4), and a second switch (9) of the series circuit (4) is arranged between a second connection (11), which is in particular connected to a reference potential of the supply voltage and/or an earth potential, of the series circuit (4) and the second reference resistor (8).

3. Resistance measuring circuit according to Claim 1 or 2,
**characterized**
**in that** the switching apparatus (16) is a multiplexer.

4. Resistance measuring circuit according to one of the preceding claims,
**characterized**
**in that** the comparison apparatus (18) is a comparator that compares a measured voltage at the first capacitor (15) with a reference voltage at the second capacitor (20) .

5. Resistance measuring circuit according to one of the preceding claims,
**characterized**
**in that** the resistance measuring circuit (1) is connected to a parallel circuit comprising a battery (13) and a capacitor (14) for providing the supply voltage.

6. Resistance measuring circuit according to one of the preceding claims,
**characterized**
**in that** the series circuit (4) comprises a plurality of measuring resistors (6) connected in series, wherein the control apparatus (2) is designed to successively determine a respective measured discharge time of the first capacitor (15) following charging via a respective one of the measuring resistors (6).

7. Resistance measuring circuit according to one of the preceding claims,
**characterized**
**in that** the control apparatus (2) is designed to carry out a temperature measurement, in particular to determine a heat quantity, via the measuring resistor (6).

8. Measuring apparatus comprising a resistance measuring circuit (1) according to one of the preceding claims.

9. Measuring apparatus according to Claim 8, **characterized**
**in that** the measuring apparatus (22) is a heat meter.

10. Resistance measuring method using a resistance measuring circuit (1) having a capacitor discharge circuit (3) and a series circuit (4) that is connected to a supply voltage and comprises at least one switch (5, 9), at least one measuring resistor (6), a first reference resistor (7) and a second reference resistor (8), wherein the capacitor discharge circuit (3) comprises a first capacitor (15) that is connectable in each case individually to the measuring resistor (6), the first reference resistor (7) and to a first input (17) of a comparison apparatus (18) of the capacitor discharge circuit (3) via a switching apparatus (16) of the capacitor discharge circuit (3), wherein the first input (17) of the comparison apparatus (18) is connected to a discharge resistor (19) of the capacitor discharge circuit (3), wherein the second reference resistor (8) is connected in parallel with a second capacitor (20) of the capacitor discharge circuit (3) and the second capacitor (20) is connected to a second input (21) of the comparison apparatus (18), comprising the steps of:
- connecting the measuring resistor (6) to the first capacitor (15) by way of the switching apparatus (16),
- charging the first capacitor (15) via the measuring resistor (6) and setting a voltage in the second capacitor (20) in accordance with a voltage at the second reference resistor (8) by closing the at least one switch (5, 9) of the series circuit (4),
- opening the at least one switch (5, 9) and ascertaining a measured discharge time of the first capacitor (15) by way of the comparison apparatus (18) using the voltage of the second capacitor (20) as reference voltage,
- connecting the first reference resistor (7) to the first capacitor (15) by way of the switching apparatus (16),
- charging the first capacitor (15) via the first reference resistor (7) and setting a voltage in the second capacitor (20) in accordance with a voltage at the second reference resistor (8) by closing the at least one switch (5, 9) of the series circuit (4),
- opening the at least one switch (5, 9) and ascertaining a reference discharge time of the first capacitor (15) by way of the comparison apparatus (18) using the voltage of the second capacitor (20) as reference voltage,
- ascertaining a measured value describing a resistance of the measuring resistor (6) from the measured discharge time and the reference discharge time.

## Revendications

1. Circuit de mesure de résistance, comprenant un dispositif de commande (2), un circuit de décharge de condensateur (3) et un montage en série (4) relié à une tension d'alimentation et composé d'au moins un commutateur (5, 9), d'au moins une résistance de mesure (6), d'une première résistance de référence (7) et d'une deuxième résistance de référence (8), dans lequel le circuit de décharge de condensateur (3) comprend un premier condensateur (15) qui peut être relié par l'intermédiaire d'un dispositif de commutation (16) du circuit de décharge de condensateur (3) respectivement individuellement à la résistance de mesure (6), à la première résistance de référence (7) et à une première entrée (17) d'un dispositif de comparaison (18) du circuit de décharge de condensateur (3), dans lequel la première entrée (17) du dispositif de comparaison (18) est reliée à une résistance de décharge (19) du circuit de décharge de condensateur (3), dans lequel la deuxième résistance de référence (8) est connectée en parallèle à un deuxième condensateur (20) du circuit de décharge de condensateur (3) et le deuxième condensateur (20) est relié à une deuxième entrée (21) du dispositif de comparaison (18), dans lequel le dispositif de commande (2) est relié au dispositif de commutation (16) et au dispositif de comparaison (18), et le dispositif de commande (2) est conçu pour relier successivement la résistance de mesure (6) et la première résistance de référence (7) au premier condensateur (15) et pour relier respectivement ensuite le premier condensateur (7) à la première entrée (17) du dispositif de comparaison (18) et pour établir par l'intermédiaire du dispositif de comparaison (18) un temps de décharge du premier condensateur (15), dans lequel le dispositif de commande (2) est en outre conçu pour établir à partir d'un temps de décharge de mesure du premier condensateur (15) chargé par l'intermédiaire de la résistance de mesure (6) et d'un temps de décharge de référence du premier condensateur (15) chargé par l'intermédiaire de la première résistance de référence (7) une valeur de mesure décrivant la valeur de résistance de la résistance de mesure (6).

2. Circuit de mesure de résistance selon la revendication 1, **caractérisé en ce qu'**un premier commutateur (5) du montage en série (4) est disposé entre la résistance de mesure (6) et une première borne (10), reliée à la tension d'alimentation, du montage en série (4), et un deuxième commutateur (9) du montage en série (4) est disposé entre une deuxième borne (11), en particulier reliée à un potentiel de référence de la tension d'alimentation et/ou à un potentiel de masse, du montage en série (4) et la deuxième résistance de référence (8).

3. Circuit de mesure de résistance selon la revendication 1 ou 2, **caractérisé en ce que** le dispositif de commutation (16) est un multiplexeur.

4. Circuit de mesure de résistance selon l'une quelconque des revendications précédentes, **caractérisé en ce que** le dispositif de comparaison (18) est un comparateur qui compare une tension de mesure au niveau du premier condensateur (15) avec une tension de référence au niveau du deuxième condensateur (20).

5. Circuit de mesure de résistance selon l'une quelconque des revendications précédentes, **caractérisé en ce que** le circuit de mesure de résistance (1) est relié à un montage en parallèle composé d'une batterie (13) et d'un condensateur (14) pour fournir la tension d'alimentation.

6. Circuit de mesure de résistance selon l'une quelconque des revendications précédentes, **caractérisé en ce que** le montage en série (4) comprend plusieurs résistances de mesure (6) connectées en série, dans lequel le dispositif de commande (2) est conçu pour déterminer successivement respectivement un temps de décharge de mesure du premier condensateur (15) après la charge par l'intermédiaire respectivement d'une des résistances de mesure (6).

7. Circuit de mesure de résistance selon l'une quelconque des revendications précédentes, **caractérisé en ce que** le dispositif de commande (2) est réalisé pour effectuer par l'intermédiaire de la résistance de mesure (6) une mesure de température, en particulier pour déterminer une quantité de chaleur.

8. Dispositif de mesure, comprenant un circuit de mesure de résistance (1) selon l'une quelconque des revendications précédentes.

9. Dispositif de mesure selon la revendication 8, **caractérisé en ce que** le dispositif de mesure (22) est un compteur de quantité de chaleur.

10. Procédé de mesure de résistance utilisant un circuit de mesure de résistance (1) comprenant un circuit de décharge de condensateur (3) et un montage en série (4) relié à une tension d'alimentation et composé d'au moins un commutateur (5, 9), d'au moins une résistance de mesure (6), d'une première résistance de référence (7) et d'une deuxième résistance de référence (8), dans lequel le circuit de décharge de condensateur (3) comprend un premier condensateur (15) qui peut relié par l'intermédiaire d'un dispositif de commutation (16) du circuit de décharge de condensateur (3) respectivement individuellement à la résistance de mesure (6), à la première résistance de référence (7) et à une première entrée (17) d'un dispositif de comparaison (18) du circuit de décharge de condensateur (3), dans lequel la première entrée (17) du dispositif de comparaison (18) est reliée à une résistance de décharge (19) du circuit de décharge de condensateur (3), dans lequel la deuxième résistance de référence (8) est connectée en parallèle à un deuxième condensateur (20) du circuit de décharge de condensateur (3), et le deuxième condensateur (20) est relié à une deuxième entrée (21) du dispositif de comparaison (18), comprenant les étapes consistant à :
- relier la résistance de mesure (6) au premier condensateur (15) par le dispositif de commutation (16),
- charger le premier condensateur (15) par l'intermédiaire de la résistance de mesure (6) et régler une tension dans le deuxième condensateur (20) selon une tension au niveau de la deuxième résistance de référence (8) en fermant ledit au moins un commutateur (5, 9) du montage en série (4),
- ouvrir ledit au moins un commutateur (5, 9) et établir un temps de décharge de mesure du premier condensateur (15) par le dispositif de comparaison (18) en utilisant la tension du deuxième condensateur (20) comme tension de référence,
- relier la première résistance de référence (7) au premier condensateur (15) par le dispositif de commutation (16),
- charger le premier condensateur (15) par l'intermédiaire de la première résistance de référence (7), et régler une tension dans le deuxième condensateur (20) selon une tension au niveau de la deuxième résistance de référence (8) en fermant ledit au moins un commutateur (5, 9) du montage en série (4),
- ouvrir ledit au moins un commutateur (5, 9), et établir un temps de décharge de référence du premier condensateur (15) par le dispositif de comparaison (18) en utilisant la tension du deuxième condensateur (20) comme tension de référence,
- établir une valeur de mesure décrivant une valeur de résistance de la résistance de mesure (6) à partir du temps de décharge de mesure et du temps de décharge de référence.
